# EUROPEAN PATENT APPLICATION

(11) **EP 4 598 309 A1**
(43) Date of publication of application: **06.08.2025**
(21) Application number: 25154015.9
(22) Date of filing: 27.01.2025
(51) Int. Cl.: H10H 20/816, H10H 20/825, H10H 29/14, H10H 29/80, H10H 20/811

(54) **LIGHT EMITTING ELEMENT AND LIGHT EMITTING DEVICE**

(30) Priority: 29.01.2024 JP 2024011127
(71) Applicant: NICHIA CORPORATION, Tokushima 774-8601 (JP)
(72) Inventor: TAKAHASHI, Yuzuru, Anan-shi, Tokushima, 774-8601 (JP); MINATO, Shunsuke, Anan-shi, Tokushima, 774-8601 (JP); KISHINO, Toshihiko, Anan-shi, Tokushima, 774-8601 (JP)
(74) Representative: Betten & Resch

(57) **Abstract**

A light emitting element includes: a first light emitting part including: a first nitride semiconductor layer containing a first conductivity type impurity, a second nitride semiconductor layer containing a second conductivity type impurity, and a first active layer positioned between the first nitride semiconductor layer and the second nitride semiconductor layer; a second light emitting part positioned above the second nitride semiconductor layer, the second light emitting part including: a third nitride semiconductor layer, a fourth nitride semiconductor layer containing a second conductivity type impurity, and a second active layer positioned between the third nitride semiconductor layer and the fourth nitride semiconductor layer. The third nitride semiconductor layer includes: a first layer that contains at least one selected from the group consisting of Be, Mg, Ca, Fe, Zn, and C, a second layer, and a third layer.

## Description

### CROSS-REFERENCE TO RELATED APPLICATION

This application claims priority to Japanese Patent Application No. 2024-011127, filed on January 29, 2024, the disclosure of which is hereby incorporated by reference in its entirety.

### FIELD

The present disclosure relates to a light emitting element and a light emitting device.

### BACKGROUND

For example, European Patent Publication No. 4086964 discloses a light emitting element in which multiple active layers are stacked on a substrate via a tunnel junction layer.

### SUMMARY

An object of certain embodiments of the present disclosure is to provide a light emitting element and a light emitting device that can reduce the leakage current flowing between the electrodes of multiple light emitting parts.

According to one aspect of the present disclosure, a light emitting element comprises: a first light emitting part, a second light emitting part, a first electrode connected to the first nitride semiconductor layer, a second electrode connected to the third layer, a third electrode connected to the second layer, and a fourth electrode connected to the fourth nitride semiconductor layer. The first light emitting part comprises a first nitride semiconductor layer, a second nitride semiconductor layer, and a first active layer positioned between the first nitride semiconductor layer and the second nitride semiconductor layer. The first nitride semiconductor layer and the second nitride semiconductor layer contain impurities, and a conductivity type of the impurity of the second nitride semiconductor layer differs from a conductivity type of the impurity of the first nitride semiconductor layer. The second light emitting part is positioned above the second nitride semiconductor layer. The second light emitting part comprises a third nitride semiconductor layer, a fourth nitride semiconductor layer, and a second active layer positioned between the third nitride semiconductor layer and the fourth nitride semiconductor layer. The third nitride semiconductor layer comprises a first layer that contains at least one selected from the group consisting of Be, Mg, Ca, Fe, Zn, and C, and a second layer positioned between the second nitride semiconductor layer and the first layer, and a third layer positioned between the first layer and the second active layer. The second layer, the third layer, and the fourth nitride semiconductor layer contain impurities, and a conductivity type of the impurity of the fourth nitride semiconductor layer differs from a conductivity type of the impurity of the second layer and the third layer.

According to another aspect of the present disclosure, a light emitting element comprises a first structure, a second structure, and a third structure. The first structure comprises a first stack part, which is a first light emitting part and comprise a first nitride semiconductor layer, a second nitride semiconductor layer, a first active layer positioned between the first nitride semiconductor layer and the second nitride semiconductor layer, a third nitride semiconductor layer, a first electrode connected to the first nitride semiconductor layer, and a second electrode connected to the third nitride semiconductor layer. The first nitride semiconductor layer and the second nitride semiconductor layer contain impurities, and a conductivity type of the impurity of the second nitride semiconductor layer differs from a conductivity type of the impurity of the first nitride semiconductor layer. The third nitride semiconductor layer contains an impurity of the conductivity type same as the conductivity type of the impurity contained in the first nitride semiconductor layer, and disposed above the second nitride semiconductor layer, The second structure comprises a second stack part, which is a second light emitting part and comprises: another first stack part; a fourth nitride semiconductor layer containing an impurity of the conductivity type same as the conductivity type of the impurity contained in the second nitride semiconductor layer; a second active layer positioned between the third nitride semiconductor layer and the fourth nitride semiconductor layer; a fifth nitride semiconductor layer containing an impurity of the conductivity type same as the conductivity type of the impurity contained in the first nitride semiconductor layer, and disposed above the fourth nitride semiconductor layer; a third electrode connected to the third nitride semiconductor layer; and a fourth electrode connected to the fifth nitride semiconductor layer. The third structure comprises a third stack part, which is a third light emitting part and comprises: another first stack part; another second stack part; a sixth nitride semiconductor layer containing an impurity of the conductivity type same as the conductivity type of the impurity contained in the second nitride semiconductor layer; and a third active layer positioned between the fifth nitride semiconductor layer and the sixth nitride semiconductor layer; a fifth electrode connected to the fifth nitride semiconductor layer; and a sixth electrode connected to the sixth nitride semiconductor layer. The third nitride semiconductor layer of the second structure comprises: a first layer that contains at least one selected from the group consisting of Be, Mg, Ca, Fe, Zn, and C; a second layer positioned between the second nitride semiconductor layer and the first layer; and a third layer positioned between the first layer and the second active layer. A thickness of the third layer is larger than a thickness of the second layer. The fifth nitride semiconductor layer of the third structure comprises: a fourth layer that contains at least one selected from the group consisting of Be, Mg, Ca, Fe, Zn, and C; a fifth layer positioned between the fourth nitride semiconductor layer and the fourth layer; and a sixth layer positioned between the fourth layer and the third active layer. A thickness of the sixth layer is larger than a thickness of the fifth layer.

According to another aspect of the present disclosure, a light emitting device comprises: one or more light emitting elements according above description; and a wiring substrate above which the one or more light emitting elements are disposed, the wiring substrate comprising a first wiring part configured to supply an electric current between the third electrode and the first electrode, and a second wiring part configured to supply an electric current between the fourth electrode and the second electrode. The light emitting device does not comprise a wavelength conversion member containing a phosphor.

According to certain embodiments of the present disclosure, a light emitting element and a light emitting device capable of reducing the leakage current flowing between the electrodes of multiple light emitting parts can be provided.

### BRIEF DESCRIPTION OF THE DRAWINGS

FIG. 1 is a schematic cross-sectional view of a light emitting element according to a first embodiment.
FIG. 2A is a schematic cross-sectional view of a portion of a light emitting element according to the first embodiment.
FIG. 2B is a schematic cross-sectional view of a portion of a light emitting element according to the first embodiment.
FIG. 3A is a schematic cross-sectional view of a portion of a light emitting element according to the first embodiment.
FIG. 3B is a schematic cross-sectional view of a portion of a light emitting element according to the first embodiment.
FIG. 4 is a schematic cross-sectional view of a light emitting element according to a second embodiment.
FIG. 5A is a schematic cross-sectional view of a portion of a light emitting element according to the second embodiment.
FIG. 5B is a schematic cross-sectional view of a portion of a light emitting element according to the second embodiment.
FIG. 6A is a schematic cross-sectional view of a portion of a light emitting element according to the second embodiment.
FIG. 6B is a schematic cross-sectional view of a portion of a light emitting element according to the second embodiment.
FIG. 7 is a schematic cross-sectional view of a light emitting device according to an embodiment.
FIG. 8 is a schematic cross-sectional view explaining a process in a method of manufacturing a light emitting element according to the first embodiment.
FIG. 9 is a schematic cross-sectional view explaining a process in the method of manufacturing a light emitting element according to the first embodiment.
FIG. 10 is a schematic cross-sectional view explaining a process in the method of manufacturing a light emitting element according to the first embodiment.
FIG. 11 is a schematic cross-sectional view explaining a process in the method of manufacturing a light emitting element according to the first embodiment.
FIG. 12 is a schematic cross-sectional view explaining a process in the method of manufacturing a light emitting element according to the first embodiment.
FIG. 13 is a schematic cross-sectional view explaining a process in the method of manufacturing a light emitting element according to the first embodiment.
FIG. 14 is a schematic cross-sectional view of a light emitting element which is a variation of the first embodiment.
FIG. 15 is a graph showing an example of current density behavior relative to the voltage in the second light emitting part of a light emitting element according to the first embodiment.
FIG. 16 is a graph showing an example of a SIMS analysis performed on a sample of a wafer having the layering structure shown in FIG. 9.

### DETAILED DESCRIPTION

Certain embodiments of the present disclosure will be described below with reference to the accompanying drawings. The dimensions, materials, shapes, relative positions of the constituents described in the embodiments are merely examples provided for explanation purposes, and are not intended to limit the constituents to those described unless otherwise specifically stated. The sizes and positional relationship of the members shown in each drawing may be exaggerated for clarity of explanation. In the description below, the same reference numerals are used to denote the same or similar members, for which detailed explanation will be omitted as appropriate. As a cross-sectional view, an end view only showing a cut section might be used.

In the explanation below, terms indicating specific directions or positions (for example, "on," "above," "upper," "under," "below," "lower" or other terms related thereto) may occasionally be used. These terms, however, are merely used to clarify the relative directions or positions in a referenced drawing. As long as the relationship between relative directions or positions indicated with the terms such as "upper," "on," "lower," "under," or the like is the same as those in a referenced drawing, the layout of the elements in other drawings or actual products outside of the present disclosure does not have to be the same as those shown in the referenced drawing. Assuming that there are two members, for example, the positional relationship expressed by the term "on/above (or under/below)" in the present specification includes the case in which two members are in contact with each other and the case in which one is positioned on/above (or under/below) the other without being in contact with the other. Furthermore, in the present specification, the thickness of a layer refers to the maximum thickness of the layer.

In the present specification, a semiconductor layer and an active layer are formed of a nitride semiconductor. Nitride semiconductors include semiconductors of all compositions obtained by varying the composition ratio x and y within their ranges in the chemical formula InₓAl_{y}Ga_{1-x-y}N (0≤x≤1, 0≤y≤1, x+y≤1). Moreover, those further containing a group V element in addition to nitrogen (N), and those further containing various elements added for controlling various physical properties such as conductivity type are also included in the nitride semiconductors.

In the present specification, the first conductivity type and the second conductivity type will be explained as the n-type and the p-type, respectively. For the first conductivity type impurity (i.e., the n-type impurity), for example, Si (silicon) or Ge (germanium) can be used. For the second conductivity type impurity (i.e., the p-type impurity), for example, Mg (magnesium) can be used. Note that the first conductivity type can be the p-type, and the second conductivity type can be the n-type. In this case, with reference to the electrodes described below, the cathode should be read as the anode, and the anode should be read as the cathode.

### First Embodiment

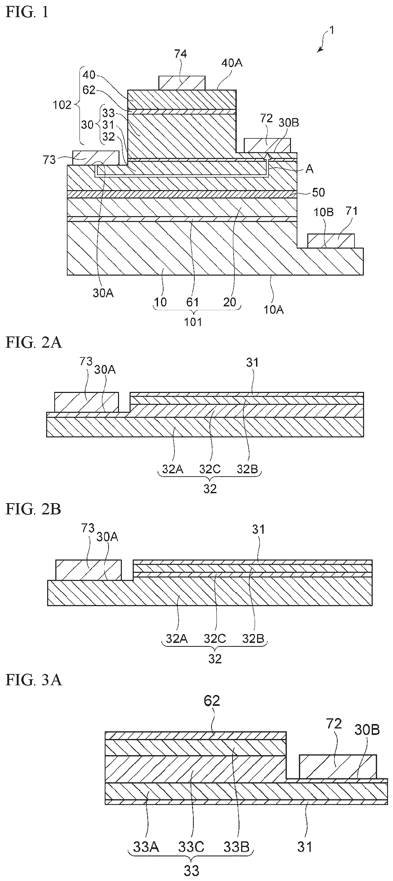

A light emitting element 1 according to a first embodiment will be explained with reference to FIG. 1 to FIG. 3B. The light emitting element 1 is a light emitting diode. As shown in FIG. 1, the light emitting element 1 includes a first light emitting part 101, a second light emitting part 102, a first electrode 71, a second electrode 72, a third electrode 73, and a fourth electrode 74.

### First Light Emitting Part 101

A first light emitting part 101 includes a first nitride semiconductor layer 10 containing a first conductivity type impurity, a second nitride semiconductor layer 20 containing a second conductivity type impurity, and a first active layer 61 positioned between the first nitride semiconductor layer 10 and the second nitride semiconductor layer 20. The first active layer 61 is an emission layer that emits light, and has, for example, a multiple quantum well (MQW) structure including multiple barrier layers and multiple well layers. The well layers of the first active layer 61 include, for example, Inₓ₁Ga₁₋ₓ₁N (0≤x1 ≤1). The concentration of the first conductivity type impurity contained in the first nitride semiconductor layer 10 may be, for example, 1 × 10¹⁸/cm⁻³ to 1 × 10¹⁹ /cm⁻³. The concentration of the second conductivity type impurity contained in the second nitride semiconductor layer 20 may be, for example, 1 × 10¹⁸/cm⁻³ to 1 × 10²⁰/cm⁻³.

The first nitride semiconductor layer 10 has a first face 10A positioned opposite the interface with the first active layer 61. The light emitting element 1 may have a substrate on the first face 10A side. The first nitride semiconductor layer 10 also has a first connection face 10B that is exposed from the first active layer 61, the second nitride semiconductor layer 20, and the second light emitting part 102. The first connection face 10B is positioned opposite the first face 10A.

### Second Light Emitting Part 102

A second light emitting part 102 is positioned above the second nitride semiconductor layer 20 of the first light emitting part 101. The second light emitting part 102 has a third nitride semiconductor layer 30 positioned above the second nitride semiconductor layer 20, a fourth nitride semiconductor layer 40 containing a second conductivity type impurity, and a second active layer 62 positioned between the third nitride semiconductor layer 30 and the fourth nitride semiconductor layer 40. The second active layer 62 is an emission layer that emits light, and has, for example, an MQW structure. The well layers of the second active layer 62 include, for example, Inₓ₂Ga₁₋ₓ₂N (0≤x2≤1). X2 may be greater than x1. In the case of an MQW structure, it has only to have at least one layer that satisfies x2>x1. This allows the second active layer 62 to emit light having a different wavelength from that of the light from the first active layer 61. The concentration of the second conductivity type impurity contained in the fourth nitride semiconductor layer 40 may be, for example, 1 × 10¹⁸/cm⁻³ to 1 × 10²⁰/cm⁻³.

The third nitride semiconductor layer 30 has a second connection face 30B and a third connection face 30A. The second connection face 30B and the third connection face 30A are exposed from the second active layer 62 and the fourth nitride semiconductor layer 40. The third nitride semiconductor layer 30 includes a first layer 31, a second layer 32, and a third layer 33. The detailed description for each of the layers 31 to 33 will be given below. The second connection face 30B is the face of a part of the third layer 33. The third connection face 30A is the face of a part of the second layer 32.

The fourth nitride semiconductor layer 40 has a fourth connection face 40A positioned opposite the interface with the second active layer 62.

### First Electrode 71

A first electrode 71 is disposed above the first connection face 10B of the first nitride semiconductor layer 10 and electrically connected to the first nitride semiconductor layer 10. For the material for the first electrode 71, for example, at least one selected from the group consisting of titanium, aluminum, platinum, rhodium, ruthenium, and gold can be used. For the first electrode 71, for example, titanium, aluminum, and platinum may be used in combination. For the materials for the other electrodes described below, for example, the same as or similar materials to those employed for the first electrode 71 can be used.

### Second Electrode 72

A second electrode 72 is disposed above the second connection face 30B of the third nitride semiconductor layer 30 and electrically connected to the third layer 33 of the third nitride semiconductor layer 30.

### Third Electrode 73

A third electrode 73 is disposed above the third connection face 30A of the third nitride semiconductor layer 30 and electrically connected to the second layer 32 of the third nitride semiconductor layer 30.

### Fourth Electrode 74

A fourth electrode 74 is disposed above the fourth connection face 40A of the fourth nitride semiconductor layer 40 and electrically connected to the fourth nitride semiconductor layer 40.

The third electrode 73 functions as the anode of the first light emitting part 101. The first electrode 71 functions as the cathode of the first light emitting part 101. The first active layer 61 emits light as an electric current is supplied thereto through the third electrode 73 and the first electrode 71. The peak wavelength of the light from the first active layer 61 is a first wavelength. The first wavelength is, for example, 360 nm to 550 nm, preferably 440 nm to 470 nm. The range of the first wavelength is not limited to this.

The fourth electrode 74 functions as the anode of the second light emitting part 102. The second electrode 72 functions as the cathode of the second light emitting part 102. The second active layer 62 emits light as an electric current is supplied thereto through the fourth electrode 74 and the second electrode 72. The peak wavelength of the light from the second active layer 62 is a second wavelength that is different from the first wavelength. The second wavelength is, for example, 450 nm to 700 nm, preferably 570 nm to 590 nm. The range of the second wavelength is not limited to this.

The light emitted by the first active layer 61 and the light emitted by the second active layer 62 are extracted from the light emitting element 1 primarily through the first face 10A side of the first nitride semiconductor layer 10.

The light emitting element 1 can be controlled by an external circuit to switch among the first emission state in which the first light emitting part 101 is allowed to emit light while the second light emitting part 102 is not, the second emission state in which the second light emitting part 102 is allowed to emit light while the first light emitting part 101 is not, and the third emission state in which the first light emitting part 101 and the second emitting part 102 are allowed to emit light simultaneously.

In the third emission state, the light emitting element 1 outputs visible light which combines the light having the first wavelength emitted by the first active layer 61 and the light having the second wavelength emitted by the second active layer 62. The light emitting element 1 emits, for example, white light. The color temperature of white light (including the correlated color temperature) is, for example, 3000 K to 7000 K.

In allowing the first active layer 61 to emit light, a positive potential is applied to the third electrode 73, and a potential lower than the third electrode 73 is applied to the first electrode 71, which applies a reversed voltage to the pn junction between the second nitride semiconductor layer 20 containing a second conductivity type impurity (p-type impurity) and the second layer 32 containing a first conductivity type impurity (n-type impurity). According to this embodiment, the light emitting element 1 includes a tunnel junction between the second nitride semiconductor layer 20 and the second layer 32. The width of the depletion layer formed by the pn junction is narrowed by raising the impurity concentration in the pn junction between the second nitride semiconductor layer 20 and the second layer 32. This allows for the tunneling of electrons present in the valence band of the p-type second nitride semiconductor layer 20 to the conduction band of the n-type second layer 32, thereby facilitating the current flow from the third electrode 73 to the first electrode 71.

The second nitride semiconductor layer 20 and the second layer 32 may be directly bonded. Alternatively, the light emitting element 1 may further include a fifth nitride semiconductor layer 50 positioned between the second nitride semiconductor layer 20 and the second layer 32. The fifth nitride semiconductor layer 50 contains a first conductivity type impurity (n-type impurity) and forms the interface (pn junction) with the second nitride semiconductor layer 20. The maximum value of the first conductivity type impurity concentration of the fifth nitride semiconductor layer 50 is higher than the maximum value of the first conductivity type impurity concentration of the first nitride semiconductor layer 10 and the maximum value of the first conductivity type impurity concentration of the third nitride semiconductor layer 30. This can narrow the width of the depletion layer formed by the pn junction between the second nitride semiconductor layer 20 and the fifth nitride semiconductor layer 50, thereby facilitating the tunnelling of electrons present in the valence band of the second nitride semiconductor layer 20 to the second layer 32. The first conductivity type impurity concentration of the fifth nitride semiconductor layer 50 may be, for example, 1 × 10¹⁸/cm⁻³ to 1 × 10²⁰/cm⁻³, or 1 × 10¹⁸/cm⁻³ to 1 × 10¹⁹/cm⁻³.

### Third Nitride Semiconductor Layer 30

The first layer 31, the second layer 32, and the third layer 33 of the third nitride semiconductor layer 30 will be described in detail.

The first layer 31 is positioned between the second layer 32 and the third layer 33. The first layer 31 contains at least one selected from the group consisting of Be (beryllium), Mg (magnesium), Ca (calcium), Fe (iron), Zn (zinc), and C (carbon). Hereinbelow, at least one selected from the group consisting of Be, Mg, Ca, Fe, Zn, and C will simply be referred to as an additive on occasion. The first layer 31 containing such an additive makes the resistivity of the first layer 31 higher than the resistivity of the second layer 32 and the resistivity of the third layer 33. This makes it difficult for an electric current to take the path (schematically indicated by the arrow A in FIG. 1) to flow from the third electrode 73 (the anode of the first light emitting part 101) towards the second electrode 72 (the cathode of the second light emitting part 102). This can reduce the leakage current flowing between the third electrode 73 (anode) of the first light emitting part 101 and the second electrode 72 (cathode) of the second light emitting part 102.

The concentration of the additive contained in the first layer 31 is higher than the concentration of the additive contained in the second layer 32 and the concentration of the additive contained in the third layer 33. The first layer 31 may further contain a first conductivity type impurity. The additive concentration of the first layer 31 is higher than the first conductivity type impurity concentration of the first layer 31. This allows electrons and holes to compensate for one another to make the resistivity of the first layer 31 even higher, further reducing the leakage current described above.

The first layer 31 is smaller than the second layer 32 and the third layer 33 in thickness. The thickness of the first layer 31 is, for example, 100 nm to 1000 nm or 200 nm to 600 nm. This can reduce the light absorption by the first layer 31 while increasing the electrical resistance of the first layer 31.

The first layer 31 preferably contains C as the additive described above. The first layer 31 can be formed by MOCVD (metalorganic chemical vapor deposition) as described below. The C concentration of the first layer 31 can be easily adjusted by the conditions set during the forming process. As compared to the other additives, carbon can easily achieve a high degree of flatness for the first layer 31 while being incorporated into the first layer 31. The C concentration of the first layer 31 is higher than the C concentration of the second layer 32 and the C concentration of the third layer 33. This can reduce the leakage current flowing between the electrodes of the multiple light emitting parts. The C concentration of the first layer 31 is, for example, 1 × 10¹⁸/cm⁻³ to 1 × 10²¹/cm⁻³, preferably 1 × 10¹⁹/cm⁻³ to 1 × 10²⁰/cm⁻³. This can reduce the leakage current flowing between the electrodes of the multiple light emitting parts while lessening the effect of light absorption.

The C concentration of the first layer 31 is higher than the concentration of the first conductivity type impurity (e.g., Si) contained in the first layer 31. This can make the resistance of the first layer 31 even higher to further reduce the leakage current described above. The C concentration of the first layer 31 may be 10 to 1000 times or 10 to 100 times the concentration of the first conductivity type impurity contained in the first layer 31. The difference between the C concentration of the first layer 31 and the Si concentration of the first layer 31 is, for example, 9 × 10¹⁷/cm⁻³ to 1 × 10²⁰/cm⁻³, preferably 1 × 10¹⁹/cm⁻³ to 1 × 10²⁰/cm⁻³. This can make the resistance of the first layer 31 even higher.

The second layer 32 is positioned between the second nitride semiconductor layer 20 and the first layer 31. In the case in which the light emitting element 1 includes the fifth nitride semiconductor layer 50 described above, the second layer 32 is positioned between the fifth nitride semiconductor layer 50 and the first layer 31. The second layer 32 contains a first conductivity type impurity. The second layer 32 can contain the additive described above. The concentration of the first conductivity type impurity contained in the second layer 32 is higher than the concentration of the additive contained in the second layer 32. This can reduce the resistance of the second layer 32 to thereby decrease the forward voltage of the first light emitting part 101. The concentration of the additive contained in the second layer 32 is, for example, 1 × 10¹⁶/cm⁻³ to 5 × 10¹⁸/cm⁻³, 1 × 10¹⁶/cm⁻³ to 1 × 10¹⁸/cm⁻³, or 1 × 10¹⁶/cm⁻³ to 1 × 10¹⁷/cm⁻³. The thickness of the second layer 32 is, for example, 100 nm to 2000 nm.

The third layer 33 is positioned between the first layer 31 and the second active layer 62, and contains a first conductivity type impurity. The third layer 33 can contain the additive described above. The concentration of the first conductivity type impurity contained in the third layer 33 is higher than the concentration of the additive contained in the third layer 33. This can reduce the resistance of the third layer 33 to thereby reduce the forward voltage of the second light emitting part 102. The concentration of the additive contained in the third layer 33 is, for example, 1 × 10¹⁶/cm⁻³ to 5 × 10¹⁸/cm⁻³, 1 × 10¹⁶/cm⁻³ to 1 × 10¹⁸/cm⁻³, or 1 × 10¹⁶/cm⁻³ to 1 × 10¹⁷/cm⁻³. The thickness of the third layer 33 is, for example, 100 nm to 2000 nm.

The third layer 33 is larger than the second layer 32 in thickness. This can reduce the sheet resistance of the third layer 33, thereby facilitating current diffusion and reducing the forward voltage of the second light emitting part 102. Reducing the thickness of the second layer 32 can reduce crystal defects. Reducing the thickness of the second layer 32 can reduce heat damage to the layers under the second layer 32 as the time required for forming the second layer 32 is reduced during the MOCVD process.

The thickness of the third layer 33 can be set, for example, to 0.5 to 1.2 times the thickness of the first nitride semiconductor layer 10. This allows a larger current to be injected into the second light emitting part 102 and can thus increase the output. For example, when the thickness of the first nitride semiconductor layer 10 is 1 µm to 3 µm, the thickness of the third layer may be 0.5 µm to 3.6 µm or 1 µm to 2 µm.

The concentrations of the additives contained in the first layer 31, the second layer 32, and the third layer 33 can be analyzed by SIMS (secondary ion mass spectrometry). Similarly, the concentrations of the first conductivity type impurity can be analyzed by SIMS. In order to analyze in more detail, the observation of a cross section by using a TEM (transmission electron microscope) and an elemental analysis by EDX (energy dispersive X-ray spectroscopy) may additionally be conducted.

As shown in FIG. 2A and FIG. 2B, the second layer 32 can include a first GaN layer 32A, a second GaN layer 32B, and a first AlGaN layer 32C. The second GaN layer 32B is located closer to the first layer 31 than the first GaN layer 32A is. The second GaN layer 32B is positioned between the first AlGaN layer 32C and the first layer 31. The first AlGaN layer 32C is positioned between the first GaN layer 32A and the second GaN layer 32B. For example, the composition of the first AlGaN layer 32C may be Alₓ₃Ga₁₋ₓ₃N (0.05<x3≤0.4, preferably 0.05≤x3≤0.2). This can lessen the degradation of the quality of the first AlGaN layer 32C. The resistivity of the first AlGaN layer 32C is higher than the resistivity of the first GaN layer 32A and the resistivity of the second GaN layer 32B. Such a first AlGaN layer 32C, same as or similar to the first layer 31, functions as a resistive layer that reduces the leakage current flowing between the third electrode 73 (anode) of the first light emitting part 101 and the second electrode 72 (cathode) of the second light emitting part 102.

In the example shown in FIG. 2A, the first AlGaN layer 32C has a third connection face 30A where the third electrode 73 is placed. The third electrode 73 is in contact with and electrically connected to the first AlGaN layer 32C at the third connection face 30A. This can reduce the leakage current flowing between the third electrode 73 (anode) of the first light emitting part 101 and the second electrode 72 (cathode) of the second light emitting part 102.

In the example shown in FIG. 2B, the first GaN layer 32A has a third connection face 30A. The third electrode 73 is in contact with and electrically connected to the first GaN layer 32A at the third connection face 30A. The contact resistance between the third electrode 73 and the first GaN layer 32A can be made lower than the contact resistance between the third electrode 73 and the first AlGaN layer 32C. This can reduce the leakage current flowing between the third electrode 73 (anode) of the first light emitting part 101 and the second electrode 72 (cathode) of the second light emitting part 102, while reducing the forward voltage for allowing the first light emitting part 101 to emit light.

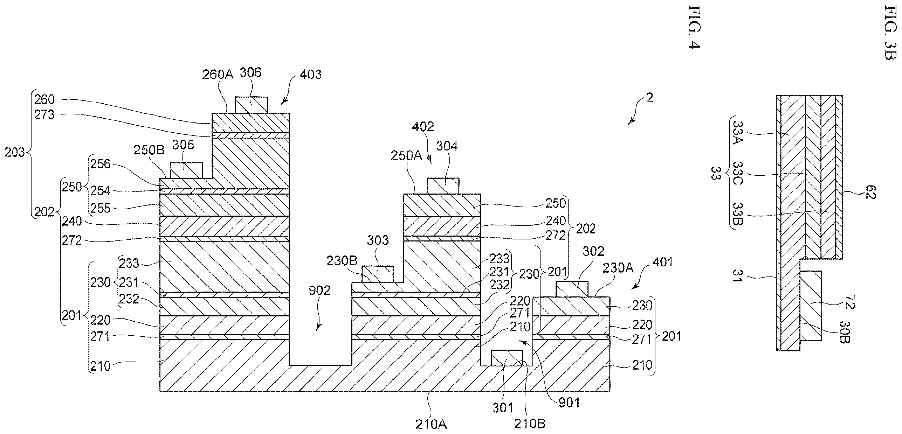

As shown in FIG. 3A and FIG. 3B, the third layer 33 can have a third GaN layer 33A, a fourth GaN layer 33B, and a second AlGaN layer 33C. The fourth GaN layer 33B is positioned farther away from the first layer 31 than the third GaN layer 33A is. The fourth GaN layer 33B is positioned between the second AlGaN layer 33C and the second active layer 62. The second AlGaN layer 33C is positioned between the third GaN layer 33A and the fourth GaN layer 33B. For example, the composition of the second AlGaN layer 33C may be Alₓ₄Ga₁₋ₓ₄N (0.05<x4≤0.4, preferably 0.05≤x4≤0.2). This can reduce the degradation of the quality of the second AlGaN layer 33C. The resistivity of the second AlGaN layer 33C is higher than the resistivity of the third GaN layer 33A and the resistivity of the fourth GaN layer 33B.

In the example shown in FIG. 3A, the second AlGaN layer 33C has a second connection face 30B where the second electrode 72 is disposed. The second electrode 72 is in contact with and electrically connected to the second AlGaN layer 33C at the second connection face 30B. At this time, the second AlGaN layer 33C, same as or similar to the first layer 31, functions as a resistive layer that reduces the leakage current that flows between the third electrode 73 (anode) of the first light emitting part 101 and the second electrode 72 (cathode) of the second light emitting part 102. This thus reduces the leakage current flowing between the third electrode 73 (anode) of the first light emitting part 101 and the second electrode 72 (cathode) of the second light emitting part 102.

In the example shown in FIG. 3B, the third GaN layer 33A has a second connection face 30B where the second electrode 72 is disposed. The second electrode 72 is in contact with and electrically connected to the third GaN layer 33A at the second connection face 30B. The contact resistance between the second electrode 72 and the third GaN layer 33A can be made lower than the contact resistance between the second electrode 72 and the second AlGaN layer 33C.

The structure shown in FIG. 2A may be combined with the structure shown in FIG. 3A or FIG. 3B. Alternatively, the structure shown in FIG. 2B may be combined with the structure shown in FIG. 3A or FIG. 3B.

### Second Embodiment

A light emitting element 2 according to a second embodiment will be explained with reference to FIG. 4 to FIG. 6B.

As shown in FIG. 4, the light emitting element 2 includes a first structure 401, a second structure 402, and a third structure 403.

### First Structure 401

A first structure 401 has a first stack part 201, a first electrode 301, and a second electrode 302.

### First Stack Part 201

A first stack part 201 includes a first nitride semiconductor layer 210 containing a first conductivity type impurity, a second nitride semiconductor layer 220 containing a second conductivity type impurity, a first active layer 271 positioned between the first nitride semiconductor layer 210 and the second nitride semiconductor layer 220, and a third nitride semiconductor layer 230 containing a first conductivity type impurity and disposed above the second nitride semiconductor layer 220. The second nitride semiconductor layer 220 is positioned between the first active layer 271 and the third nitride semiconductor layer 230. The first active layer 271 is an emission layer that emits light, and has an MQW structure, for example. The first stack part 201 is a first light emitting part.

The first nitride semiconductor layer 210 has a first face 210A positioned opposite the interface with the first active layer 271. The light emitting element 2 may include a substrate on the first 210A side. The first nitride semiconductor layer 210 has a first connection face 210B exposed from the third nitride semiconductor layer 230, the second nitride semiconductor layer 220, and the first active layer 271. The first connection face 210B is positioned opposite the first face 210A.

The third nitride semiconductor layer 230 has a third connection face 230A positioned opposite the interface with the second nitride semiconductor layer 220.

### First Electrode 301

A first electrode 301 is disposed above the first connection face 210B of the first nitride semiconductor layer 210 and electrically connected to the first nitride semiconductor layer 210.

### Second Electrode 302

A second electrode 302 is disposed above the third connection face 230A of the third nitride semiconductor layer 230 and electrically connected to the third nitride semiconductor layer 230.

The second electrode 302 functions as the anode of the first structure 401. The first electrode 301 functions as the cathode of the first structure 401. The first active layer 271 of the first structure 401 emits light as an electric current is supplied to the first active layer 271 through the second electrode 302 and the first electrode 301. The peak wavelength of the light emitted from the first active layer 271 of the first structure 401 is a first wavelength. The first wavelength is, for example, in a range of 440 nm to 470 nm. The range of the first wavelength is not limited to this.

### Second Structure 402

A second structure 402 includes a second stack part 202, a third electrode 303, and a fourth electrode 304.

### Second Stack Part 202

A second stack part 202 includes the first stack part 201, a fourth nitride semiconductor layer 240 containing a second conductivity type impurity, a second active layer 272 positioned between the third nitride semiconductor layer 230 and the fourth nitride semiconductor layer 240, and a fifth nitride semiconductor layer 250 containing a first conductivity type impurity and disposed above the fourth nitride semiconductor layer 240. The fourth nitride semiconductor layer 240 is positioned between the second active layer 272 and the fifth nitride semiconductor layer 250. The second active layer 272 is an emission layer that emits light and has an MQW structure, for example. The second stack part 202 is a second light emitting part.

The first stack part 201 of the first structure 401 and the first stack part 201 of the second structure 402 are positioned apart from one another while interposing a first groove 901. The first connection face 210B of the first structure 401 defines the bottom of the first groove 901. The width of the first groove 901 (i.e., the distance between the first stack part 201 of the first structure 401 and the first stack part 201 of the second structure 402) is, for example, 1 µm to 20 µm. In the light emitting element 2 of the second embodiment, the electrical isolation between the light emitting parts works effectively when the width of the first groove 901 is relatively small as described above. This is similarly true in the case of the second groove 902 described below.

The third nitride semiconductor layer 230 of the second structure 402 has a third connection face 230B. The third connection face 230B is exposed from the second active layer 272, the fourth nitride semiconductor layer 240, and the fifth nitride semiconductor layer 250. The third nitride semiconductor layer 230 includes a first layer 231, a second layer 232, and a third layer 233. Each of the layers 231 to 233 will be described in detail below. The third connection face 230B is the face of a part of the third layer 233.

The fifth nitride semiconductor layer 250 has a fourth connection face 250A positioned opposite the interface with the fourth nitride semiconductor layer 240.

### Third Electrode 303

A third electrode 303 is disposed above the third connection face 230B of the third nitride semiconductor layer 230 and electrically connected to the third nitride semiconductor layer 230.

### Fourth Electrode 304

A fourth electrode 304 is disposed above the fourth connection face 250A of the fifth nitride semiconductor layer 250 and electrically connected to the fifth nitride semiconductor layer 250.

The fourth electrode 304 functions as the anode of the second structure 402. The third electrode 303 functions as the cathode of the second structure 402. The second active layer 272 of the second structure 402 emits light as an electric current is supplied to the second active layer 272 through the fourth electrode 304 and the third electrode 303. The peak wavelength of the light emitted from the second active layer 272 of the second structure 402 is a second wavelength. The second wavelength is, for example, in a range of 570 nm to 590 nm. The range of the second wavelength is not limited to this.

### Third Structure 403

A third structure 403 includes a third stack part 203, a fifth electrode 305, and a sixth electrode 306.

### Third Stack Part 203

A third stack part 203 includes the first stack part 201, the second stack part 202, a sixth nitride semiconductor layer 260 containing a second conductivity type impurity, and a third active layer 273 positioned between the fifth nitride semiconductor layer 250 and the sixth nitride semiconductor layer 260. The third active layer 273 is an emission layer that emits light and has, for example, an MQW structure. The third stack part 203 is a third emitting part.

The first stack part 201 of the second structure 402 and the first stack part 201 of the third structure 403 are positioned apart from one another while interposing a second groove 902. The width of the second groove 902 (the distance between the first stack part 201 of the second structure 402 and the first stack part 201 of the third structure 403) is, for example, 1 µm to 20 µm.

The fifth nitride semiconductor layer 250 of the third structure 403 has a fifth connection face 250B. The fifth connection face 250B is exposed from the third active layer 273 and the sixth nitride semiconductor layer 260. The fifth nitride semiconductor layer 250 includes a fourth layer 254, a fifth layer 255, and a sixth layer 256. Each of the layers 254 to 256 will be described in detail below. The fifth connection face 250B is the face of a part of the sixth layer 256.

The sixth nitride semiconductor layer 260 has a sixth connection face 260A positioned opposite the interface with the third active layer 273.

### Fifth Electrode 305

A fifth electrode 305 is disposed above the fifth connection face 250B of the fifth nitride semiconductor layer 250 and electrically connected to the fifth nitride semiconductor layer 250.

### Sixth Electrode 306

A sixth electrode 306 is disposed above the sixth connection face 260A of the sixth nitride semiconductor layer 260 and electrically connected to the sixth nitride semiconductor layer 260.

The sixth electrode 306 functions as the anode of the third structure 403. The fifth electrode 305 functions as the cathode of the third structure 403. The third active layer 273 of the third structure 403 emits light as an electric current is supplied to the third active layer 273 through the sixth electrode 306 and the fifth electrode 305. The peak wavelength of the light emitted from the third active layer 273 of the third structure 403 is a third wavelength. The third wavelength is, for example, in a range of 590 nm to 770 nm. The range of the third wavelength is not limited to this.

The first wavelength of the light emitted by the first active layer 271 of the first structure 401, the second wavelength of the light emitted by the second active layer 272 of the second structure 402, and the third wavelength of the light emitted by the third active layer 273 of the third structure 403 are different from one another. For example, the first wavelength is shorter than the second wavelength, and the second wavelength is shorter than the third wavelength.

The light emitted by the first active layer 271 of the first structure 401, the light emitted by the second active layer 272 of the second structure 402, and the light emitted by the third active layer 273 of the third structure 403 are extracted primarily from the first face 210A side of the first nitride semiconductor layer 210.

The light emitting element 2 is capable of allowing the first active layer 271 of the first structure 401, the second active layer 272 of the second structure 402, and the third active layer 273 of the third structure 403 to emit light individually. It is capable of individually controlling the light emission of the first active layer 271 of the first structure 401, the second active layer 272 of the second structure 402, and the third active layer 273 of the third structure 403. It is capable of allowing two of the first active layer 271 of the first structure 401, the second active layer 272 of the second structure 402, and the third active layer 273 of the third structure 403 to emit light simultaneously. It is capable of allowing all of the first active layer 271 of the first structure 401, the second active layer 272 of the second structure 402, and the third active layer 273 of the third structure 403 to emit light simultaneously. The first structure 401, the second structure 402, and the third structure 403 can configure a pixel that combines three primary colors, RGB, for example.

### Third Nitride Semiconductor Laver 230 of Second Structure 402

The first layer 231, the second layer 232, and the third layer 233 of the third nitride semiconductor layer 230 of the second structure 402 will be explained in detail.

The first layer 231 is positioned between the second layer 232 and the third layer 233. The first layer 231 contains an additive same as or similar to that contained in the first layer 31 of the first embodiment described above. The first layer 231 containing such an additive makes the resistivity of the first layer 231 higher than the resistivity of the second layer 232 and the resistivity of the third layer 233. This makes it difficult for an electric current to take the path to flow from the fourth electrode 304 (the anode of the second structure 402) towards the first electrode 301 (the cathode of the first structure 401). Accordingly, the leakage current flowing between the fourth electrode 304 (anode) of the second structure 402 and the first electrode 301 (cathode) of the first structure 401 can be reduced.

The first layer 231 can also reduce the leakage current flowing between the second electrode 302 (the anode of the first structure 401) and the third electrode 303 (the cathode of the second structure 402).

Furthermore, the first layer 231 can reduce the leakage current flowing between the sixth electrode 306 (the anode of the third structure 403) and the third electrode 303 (the cathode of the second structure 402).

The concentration of the additive contained in the first layer 231 is higher than the concentration of the additive contained in the second layer 232 and the concentration of the additive contained in the third layer 233. The first layer 231 can further contain a first conductivity type impurity. The concentration of the additive contained in the first layer 231 is higher than the concentration of the first conductivity type impurity contained in the first layer 231. This can make the resistance of the first layer 231 higher, further reducing the leakage current described above.

The first layer 231 is smaller than the second layer 232 and the third layer 233 in thickness. The thickness of the first layer 231 is, for example, 100 nm to 1000 nm.

The first layer 231, as described above, preferably contains C as the additive described above from the standpoint of concentration adjustability and flatness. The C concentration of the first layer 231 is higher than the C concentration of the second layer 232 and the C concentration of the third layer 233. The C concentration of the first layer 231 is, for example, 1 × 10¹⁸/cm⁻³ to 1 × 10²¹/cm⁻³, preferably 1 × 10¹⁹/cm⁻³ to 1 × 10²⁰/cm⁻³. This can reduce the leakage current flowing between the electrodes of multiple light emitting parts while lessening the effect of light absorption.

The C concentration of the first layer 231 is higher than the concentration of the first conductivity type impurity (e.g., Si) contained in the first layer 231. This can make the resistance of the first layer 231 higher, further reducing the leakage current described above. The difference between the C concentration and the Si concentration of the first layer 231 is, for example, 9 × 10¹⁷/cm⁻³ to 1 × 10²⁰/cm⁻³, preferably 1 × 10¹⁹/cm⁻³ to 1 × 10²⁰/cm⁻³.

The second layer 232 is positioned between the second nitride semiconductor layer 220 and the first layer 231. The second layer 232 contains a first conductivity type impurity. The second layer 232 can further contain the additive described above. The concentration of the first conductivity type impurity contained in the second layer 232 is higher than the concentration of the additive contained in the second layer 232. This can reduce the resistance of the second layer 232, thereby reducing the forward voltage of the second structure 402. The concentration of the additive contained in the second layer 232 is, for example, 1 × 10¹⁶/cm⁻³ to 5 × 10¹⁸/cm⁻³, 1 × 10¹⁶/cm⁻³ to 1 × 10¹⁸/cm⁻³, or 1 × 10¹⁶/cm⁻³ to 1 × 10¹⁷/cm⁻³.

The third layer 233 is positioned between the first layer 231 and the second active layer 272 and contains a first conductivity type impurity. The third layer 233 can further contain the additive described above. The concentration of the first conductivity type impurity contained in the third layer 233 is higher than the concentration of the additive contained in the third layer 233. This can reduce the resistance of the third layer 233 thereby reducing the forward voltage of the second structure 402. The concentration of the additive contained in the third layer 233 is, for example, 1 × 10¹⁶/cm⁻³ to 5 × 10¹⁸/cm⁻³, 1 × 10¹⁶/cm⁻³ to 1 × 10¹⁸/cm⁻³, or 1 × 10¹⁶/cm⁻³ to 1 × 10¹⁷/cm⁻³.

The third layer 233 is larger than the second layer 232 in thickness. This can reduce the sheet resistance of the third layer 233, thereby facilitating current diffusion and improving the output of the second structure 402. Making the second layer 232 thin can reduce crystal defects. Reducing the thickness of the second layer 232 can reduce heat damage to the layers under the second layer 232 as the time required for forming the second layer 232 is reduced during the MOCVD process. The thickness of the second layer 232 is, for example, 100 nm to 2000 nm. The thickness of the third layer 233 is, for example, 100 nm to 2000 nm.

### Fifth Nitride Semiconductor Laver 250 of Third Structure 403

The fourth layer 254, the fifth layer 255, and the sixth layer 256 of the fifth nitride semiconductor layer 250 of the third structure 403 will be explained in detail.

The fourth layer 254 is positioned between the fifth layer 255 and the sixth layer 256. The fourth layer 254 contains an additive same as or similar to that contained in the first layer 31 of the first embodiment described above. The fourth layer 254 containing such an additive makes the resistivity of the fourth layer 254 higher than the resistivity of the fifth layer 255 and the resistivity of the sixth layer 256. This makes it difficult for an electric current to take the path to flow from the sixth electrode 306 (the anode of the third structure 403) towards the third electrode 303 (the cathode of the second structure 402) and the first electrode 301 (the cathode of the first structure 401). This can reduce the leakage current flowing between the sixth electrode 306 of the third structure 403 and the third electrode 303 of the second structure 402, and the leakage current flowing between the sixth electrode 306 of the third structure 403 and the first electrode 301 of the first structure 401.

The concentration of the additive contained in the fourth layer 254 is higher than the concentration of the additive contained in the fifth layer 255 and the concentration of the additive contained in the sixth layer 256. The fourth layer 254 may further contain a first conductivity type impurity. The concentration of the additive contained in the fourth layer 254 is higher than the concentration of the first conductivity type impurity contained in the fourth layer 254. This can make the resistance of the fourth layer 254 higher, thereby further reducing the leakage current described above.

The fourth layer 254 is smaller than the fifth layer 255 and the sixth layer 256 in thickness. The thickness of the fourth layer 254 is, for example, 100 nm to 1000 nm.

The fourth layer 254, as described above, preferably contains C as the additive described above from the standpoint of concentration adjustability and flatness. The C concentration of the fourth layer 254 is higher than the C concentration of the fifth layer 255 and the C concentration of the sixth layer 256. The C concentration of the fourth layer 254 is, for example, 1 × 10¹⁸/cm⁻³ to 1 × 10²¹/cm⁻³, preferably 1 × 10¹⁹/cm⁻³ to 1 × 10²⁰/cm⁻³.

The C concentration of the fourth layer 254 is higher than the concentration of the first conductivity type impurity (e.g., Si) contained in the fourth layer 254. This can make the resistance of the fourth layer 254 higher, thereby further reducing the leakage current described above. The difference between the C concentration and the Si concentration of the fourth layer 254 is, for example, 9 × 10¹⁷/cm⁻³ to 1 × 10²⁰/cm⁻³, preferably 1 × 10¹⁹/cm⁻³ to 1 × 10²⁰/cm⁻³.

The fifth layer 255 is positioned between the fourth nitride semiconductor layer 240 and the fourth layer 254. The fifth layer 255 contains a first conductivity type impurity. The fifth layer 255 can contain the additive described above. The concentration of the first conductivity type impurity contained in the fifth layer 255 is higher than the concentration of the additive contained in the fifth layer 255. This can reduce the resistance of the fifth layer 255 thereby reducing the forward voltage of the third structure 403. The concentration of the additive contained in the fifth layer 255 is, for example, 1 × 10¹⁶/cm⁻³ to 5 × 10¹⁸/cm⁻³, 1 × 10¹⁶/cm⁻³ to 1 × 10¹⁸/cm⁻³, or 1 × 10¹⁶/cm⁻³ to 1 × 10¹⁷/cm⁻³.

The sixth layer 256 is positioned between the fourth layer 254 and the third active layer 273, and contains a first conductivity type impurity. The sixth layer 256 can contain the additive described above. The concentration of the first conductivity type impurity contained in the sixth layer 256 is higher than the concentration of the additive contained in the sixth layer 256. This can reduce the resistance of the sixth layer 256 thereby reducing the forward voltage of the third structure 403. The concentration of the additive contained in the sixth layer 256 is, for example, 5 × 10¹⁸/cm⁻³ or lower, 1 × 10¹⁸/cm⁻³ or lower, or 1 × 10¹⁷/cm⁻³ or lower.

The sixth layer 256 is larger than the fifth layer 255 in thickness. This can lower the sheet resistance of the sixth layer 256, thereby facilitating current diffusion and increasing the output of the third structure 403. Reducing the thickness of the fifth layer 255 can reduce crystal defects. Reducing the thickness of the fifth layer 255 can reduce heat damage to the layers under the fifth layer 255 as the time required for forming the fifth layer 255 is reduced during the MOCVD process. The thickness of the fifth layer 255 is, for example, 100 nm to 2000 nm. The thickness of the sixth layer 256 is, for example, 100 nm to 2000 nm.

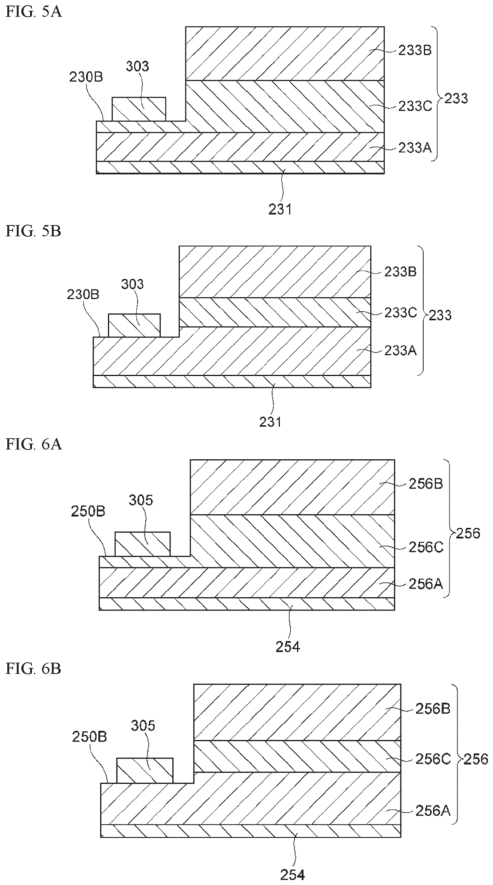

As shown in FIG. 5A and FIG. 5B, the third layer 233 can include a first GaN layer 233A, a second GaN layer 233B, and a first AlGaN layer 233C. The first GaN layer 233A is positioned between the first AlGaN layer 233C and the first layer 231. The second GaN layer 233B is positioned farther away from the first layer 231 than the first GaN layer 233A is. The first AlGaN layer 233C is positioned between the first GaN layer 233A and the second GaN layer 233B. The Al composition ratio of the first AlGaN layer 233C is higher than the Al composition ratio of the first GaN layer 233A and the Al composition ratio of the second GaN layer 233B. The resistivity of the first AlGaN layer 233C is higher than the resistivity of the first GaN layer 233A and the resistivity of the second GaN layer 233B. Such a first AlGaN layer 233C, same as or similar to the first layer 231, functions as a resistive layer that reduces the leakage current flowing between the fourth electrode 304 (the anode of the second structure 402) and the cathodes of the other structures (the first electrode 301 and the fifth electrode 305).

In the example shown in FIG. 5A, the first AlGaN layer 233C has a third connection face 230B where the third electrode 303 is disposed. The third electrode 303 is in contact with and electrically connected to the first AlGaN layer 233C at the third connection face 230B.

In the example shown in FIG. 5B, the first GaN layer 233A has a third connection face 230B. The third electrode 303 is in contact with and electrically connected to the first GaN layer 233A at the third connection face 230B. The contact resistance between the third electrode 303 and the first GaN layer 233A can be made lower than the contact resistance between the third electrode 303 and the first AlGaN layer 233C.

As shown in FIG. 6A and FIG. 6B, the sixth layer 256 can include a third GaN layer 256A, a fourth GaN layer 256B, and a second AlGaN layer 256C. The third GaN layer 256A is positioned between the second AlGaN layer 256C and the fourth layer 254. The fourth GaN layer 256B is positioned farther away from the fourth layer 254 than the third GaN layer 256A is. The second AlGaN layer 256C is positioned between the third GaN layer 256A and the fourth GaN layer 256B. The Al composition ratio of the second AlGaN layer 256C is higher than the Al composition ratio of the third GaN layer 256A and the Al composition ratio of the fourth GaN layer 256B. The resistivity of the second AlGaN layer 256C is higher than the resistivity of the third GaN layer 256A and the resistivity of the fourth GaN layer 256B. Such a second AlGaN layer 256C, same as or similar to the fourth layer 254, functions as a resistive layer that reduces the leakage current flowing between the sixth electrode 306 (the anode of the third structure 403) and the cathodes of the other structures (the third electrode 303 and the first electrode 301).

In the example shown in FIG. 6A, the second AlGaN layer 256C has a fifth connection face 250B where the fifth electrode 305 is disposed. The fifth electrode 305 is in contact with and electrically connected to the second AlGaN layer 256C at the fifth connection face 250B.

In the example shown in FIG. 6B, the third GaN layer 256A has a fifth connection face 250B where the fifth electrode 305 is disposed. The fifth electrode 305 is in contact with and electrically connected to the third GaN layer 256A at the fifth connection face 250B. The contact resistance between the fifth electrode 305 and the third GaN layer 256A can be made lower than the contact resistance between the fifth electrode 305 and the second AlGaN layer 256C.

The structure shown in FIG. 5A can be combined with the structure shown in FIG. 6A or FIG. 6B. Alternatively, the structure shown in FIG. 5B can be combined with the structure shown in FIG. 6A or FIG. 6B.

A tunnel junction may be further formed by forming the nitride semiconductor layer explained with reference to FIG. 1 between the second nitride semiconductor layer 220 and the third nitride semiconductor layer 230, and between the fourth nitride semiconductor layer 240 and the fifth nitride semiconductor layer 250.

### Light Emitting Device

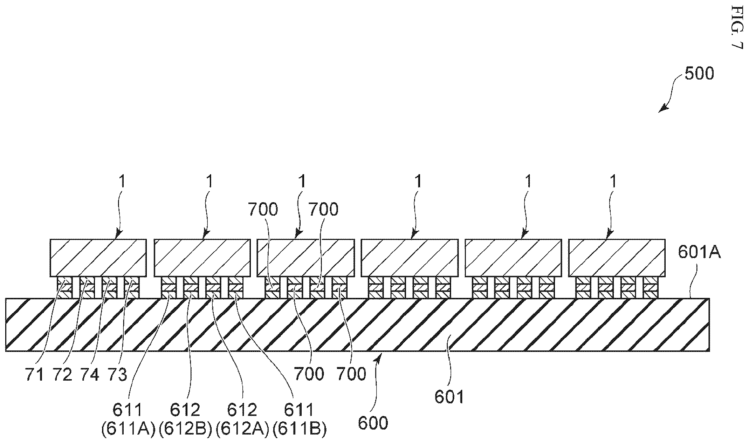

A light emitting device 500 according to an embodiment will be described with reference to FIG. 7.

The light emitting device 500 includes a wiring substrate 600 and one or more light emitting elements 1 disposed above the wiring substrate 600. In the example shown in FIG. 7, for the light emitting elements used in the light emitting device 500, the light emitting elements 1 according to the first embodiment are shown. The light emitting elements 1 are placed above the wiring substrate 600 such that their faces having the first electrodes 71 to 74 face the wiring substrate 600. The light emitting device 500 can include a plurality of light emitting elements 1. In this case, light emission of the light emitting elements 1 can be individually controlled. The light emitting device 500 includes, for example, 1000 or more or 10000 or more light emitting elements 1, and can be used as a headlight of a vehicle. The light emitting device 500 can be used in a display device. The light emitting device 500 may include the light emitting elements 2 according to the second embodiment.

The wiring substrate 600 has an insulation base 601, a first wiring part 611, and a second wiring part 612. The insulation base 601 has a mounting face 601A above which the light emitting elements 1 are disposed. The first wiring part 611 and the second wiring part 612 are disposed above the mounting face 601A of the insulation base 601.

The third electrode 73 and the first electrode 71 of a light emitting element 1 are electrically connected to the first wiring part 611. The first wiring part 611 conducts an electric current to the third electrode 73 and the first electrode 71 to allow the first active layer 61 of the first light emitting part 101 to emit light. The first wiring part 611 includes a first portion 611A that is electrically connected to the first electrode 71, and a third portion 611B that is electrically connected to the third electrode 73. The third electrode 73 and the first electrode 71 are bonded to the first wiring part 611 via a bonding member 700 such as solder, for example. The third electrode 73 and the first electrode 71 may be directly bonded to the first wiring part 611.

The fourth electrode 74 and the second electrode 72 of the first light emitting element 1 is electrically connected to the second wiring part 612. The second wiring part 612 conducts an electric current to the fourth electrode 74 and the second electrode 72 to allow the second active layer 62 of the second light emitting part 102 to emit light. The second wiring part 612 includes a fourth portion 612A that is electrically connected to the fourth electrode 74, and a second portion 612B that is electrically connected to the second electrode 72. The fourth electrode 74 and the second electrode 72 are bonded to the second wiring part 612 via a bonding member 700 such as solder, for example. The fourth electrode 74 and the second electrode 72 may be directly bonded to the second wiring part 612.

The light emitting device 500 outputs visible light by combining the light having a first wavelength from the first active layer 61 and the light having a second wavelength from the second active layer 62. The light emitting device 500 emits white light, for example. The color temperature of white light (including the correlated color temperature) is, for example, 3000 K to 7000 K.

Examples of conventional light emitting devices that emit white light include one provided with a wavelength conversion member containing a phosphor disposed over a plurality of light emitting elements so as to output white light by combining the light emitted by the light emitting elements and the wavelength-converted light emitted by the wavelength conversion member. The phosphor is excited by the light from the light emitting elements and emits light in every direction. In this configuration, in the case in which one light emitting element is emitting light and an adjacent light emitting element is not emitting light, the light from the phosphor located above the light emitting element that is emitting light propagates into a non-emission region above the light emitting element that is not emitting light. This can reduce the contrast between the emission region and the non-emission region. The reduced contrast between the emission region and the non-emission region can result in a blurry outline of the light output by the light emitting device. Furthermore, the light emitted by one light emitting element can be scattered by the phosphor located above it to propagate into a non-emission region above another light emitting element. This can also reduce the contrast between the emission region and the non-emission region.

In contrast, the light emitting device 500 according to this embodiment does not include a wavelength conversion member containing a phosphor. The light emitting device 500 achieves white light by combining the light having a first wavelength and the light having a second wavelength emitted by the light emitting elements 1. The light emitted by the light emitting elements 1 has higher directivity than the light emitted by a wavelength conversion member containing a phosphor. Accordingly, when individually controlling light emission of multiple light emitting elements 1, it is difficult for the light in the emission region of an activated light emitting element 1 to propagate into the non-emission region of a non-activated light emitting element 1. Thus, the light emitted from the emission region has a high directivity, allowing the emission region to stand out in contrast to a non-emission region.

### Method of Manufacturing Light Emitting Element

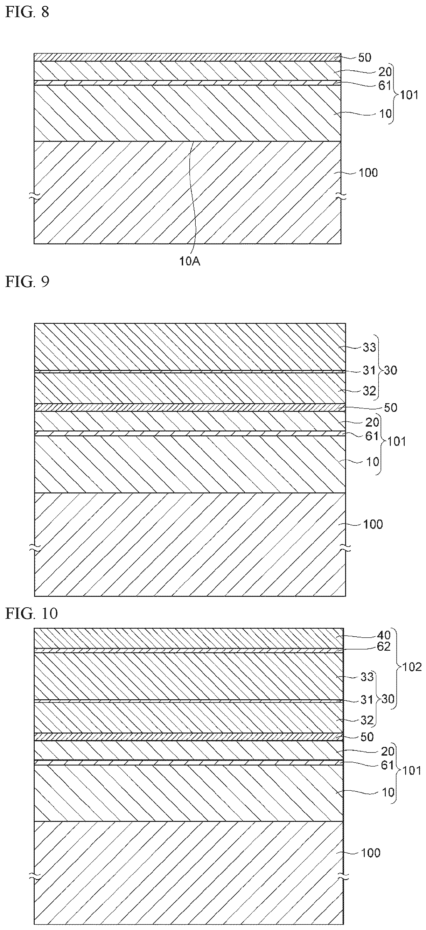

A method of manufacturing a light emitting element 1 according to the first embodiment will be explained with reference to FIG. 8 to FIG. 13.

As shown in FIG. 8, a method of manufacturing a light emitting element 1 includes providing a first light emitting part 101 in which a first nitride semiconductor layer 10 containing a first conductivity type impurity, a first active layer 61, and a second nitride semiconductor layer 20 containing a second conductivity type impurity are successively stacked above a substrate 100. A first light emitting part 101 can be provided by successively forming above a substrate 100 a first nitride semiconductor layer 10 containing a first conductivity type impurity, a first active layer 61, and a second nitride semiconductor layer 20 by MOCVD in a pressure and temperature adjustable chamber, for example.

A substrate 100 is placed in a process chamber. Each layer is formed above the substrate 100 by MOCVD while heating the substate 100 and introducing source gases into the process chamber. For the substrate 100, for example, a sapphire substrate can be used.

The method of manufacturing a light emitting element 1 includes, as needed, forming a fifth nitride semiconductor layer 50 above the second nitride semiconductor layer 20 such that the concentration of the first conductivity type impurity is higher than those of the first nitride semiconductor layer 10 and the third nitride semiconductor layer 30 that will be formed in the subsequent step.

As shown in FIG. 9, the method of manufacturing a light emitting element 1 includes forming above the second nitride semiconductor layer 20 a third nitride semiconductor layer 30. The third nitride semiconductor layer 30 is formed by MOCVD, for example. The third nitride semiconductor layer 30 is formed by heating the substrate 100 and introducing ammonia gas into the process chamber. The third nitride semiconductor layer 30 contains at least N (nitrogen) and Ga (gallium). Ammonia gas is a source gas for N. As a source gas for Ga, trimethylgallium or triethylgallium is further introduced into the process chamber to form the third nitride semiconductor layer 30.

In the middle of forming a third nitride semiconductor layer 30, at least either the heating temperature of the substrate 100 or the flow rate of ammonia gas is lowered. This can facilitate the incorporation of the C remaining in the process chamber and/or the C in the Ga source gas into the third nitride semiconductor layer 30, thereby forming a first layer 31 in the third nitride semiconductor layer 30. In other words, the first layer 31 is formed above the second layer 32. In the middle of forming a third nitride semiconductor layer 30, the heating temperature of the substrate 100 may be lowered only by 100°C to 200°C as compared to the temperature used in forming the second layer 32. In the middle of forming a third nitride semiconductor layer 30, the ammonia gas flow rate may be lowered to 1% to 10% of the ammonia gas flow rate for forming the second layer 32, for example. The ammonia gas flow rate may be lowered to 0.1% to 0.5% of the ammonia gas flow rate for forming the first nitride semiconductor layer 10, for example. The first layer 31 is positioned between the second layer 32 and the third layer 33. The C concentration of the first layer 31 is higher than the C concentration of the second layer 32 and the C concentration of the third layer 33.

The heating temperature of the substrate 100 used when forming the first layer 31 is lower than the heating temperature of the substrate 100 used when forming the second layer 32, and is lower than the heating temperature of the substrate 100 used when forming the third layer 33. Alternatively, the ammonia gas flow rate used when forming the first layer 31 is lower than the ammonia gas flow rate used when forming the second layer 32, and is lower than the ammonia gas flow rate used when forming the third layer 33. Alternatively, the heating temperature of the substrate 100 and the ammonia gas flow rate used when forming the first layer 31 are lower than the heating temperatures of the substrate 100 and the ammonia gas flow rates used when forming the second layer 32, and are lower than the heating temperatures of the substrate 100 and the ammonia gas flow rates used when forming the third layer 33.

As shown in FIG. 10, the method of manufacturing a light emitting element 1 includes providing a second light emitting part 102 in which a second active layer 62 and a fourth nitride semiconductor layer 40 containing a second conductivity type impurity are successively stacked above the third nitride semiconductor layer 30. The second light emitting part 102 can be provided by successively forming a second active layer 62 and a fourth nitride semiconductor layer 40 above the third nitride semiconductor layer 30 by MOCVD, for example.

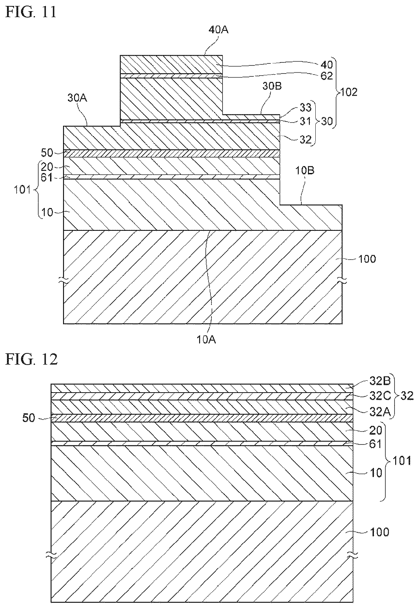

As shown in FIG. 11, the method of manufacturing a light emitting element 1 includes exposing the third nitride semiconductor layer 30 and the first nitride semiconductor layer 10 by partially etching off the second light emitting part 102 and the first light emitting part 101. For example, using a resist mask, the second light emitting part 102 and the first light emitting part 101 are etched from the upper face side of the nitride semiconductor layer 40 by RIE (reactive ion etching). A first connection face 10B of the first nitride semiconductor layer 10 is formed by etching the second light emitting part 102 and the first light emitting part 101. A second connection face 30B and a third connection face 30A of the third nitride semiconductor layer 30 are formed by etching the second light emitting part 102.

The method of manufacturing a light emitting element 1 includes disposing first to fourth electrodes 71 to 74 as shown in FIG. 1. The first electrode 71 is disposed above the first connection face 10B, the second electrode 72 is disposed above the second connection face 30B, the third electrode 73 is disposed above the third connection face 30A, and the fourth electrode 74 is disposed above the fourth connection face 40A, which is the upper face of the fourth nitride semiconductor layer 40.

In the method of manufacturing a light emitting element 1, the substrate 100 may be removed. In the method of manufacturing a light emitting element 1, the first face 10A of the first nitride semiconductor layer 10 that is exposed after removing the substrate 100 may be roughened.

As shown in FIG. 12, the process of forming a third nitride semiconductor layer 30 can include forming GaN layers (a first GaN layer 32A and a second GaN layer 32B), and forming a first AlGaN layer 32C to be positioned in the intermediate portion of the GaN layers (the first GaN layer 32A and the second GaN layer 32B) before lowering at least either the heating temperature of the substrate 100 or the ammonia gas flow rate, i.e., before forming the first layer 31 described above.

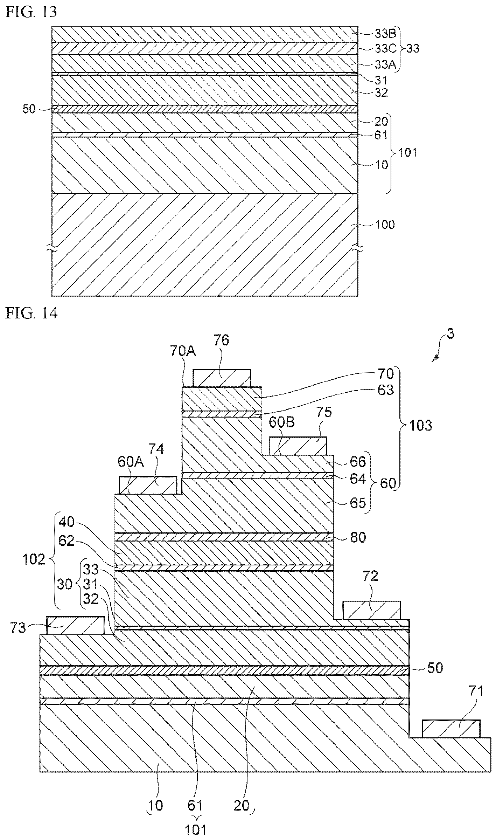

As shown in FIG. 13, the process of forming a third nitride semiconductor layer 30 can include forming GaN layers (a third GaN layer 33A and a fourth GaN layer 33B), and forming a second AlGaN layer 33C to be positioned in the intermediate portion of the GaN layers (the third GaN layer 33A and the fourth GaN layer 33B) after lowering at least either the heating temperature of the substrate 100 or the ammonia gas flow rate, i.e., after forming the first layer 31 described above.

Under the same RIE conditions, the etching rate of an AlGaN layer is slower than the etching rate of a GaN layer. Accordingly, as shown in FIG. 12, the first AlGaN layer 32C formed in the intermediate portion of the second layer 32 of the third nitride semiconductor layer 30 can provide an indication of an etching rate change, making it easier to stop the etching at a predetermined depth when forming a third connection face 30A of the second layer 32. As shown in FIG. 2A, etching may be stopped in the intermediate portion of the first AlGaN layer 32C. Alternatively, as shown in FIG. 2B, etching may be stopped after passing through the first AlGaN layer 32C and reaching the first GaN layer 32A. At this time, because the materials change from AlGaN to GaN, the etching rate increases. This etching rate change becomes the indication for stopping the etching.

As shown in FIG. 13, the second AlGaN layer 33C formed in the intermediate portion of the third layer 33 of the third nitride semiconductor layer 30 can make it easier to stop etching at a predetermined depth when forming a second connection face 30B of the third layer 33. As shown in FIG. 3A, etching may be stopped in the intermediate portion of the second AlGaN layer 33C. Alternatively, as shown in FIG. 3B, etching may be stopped after passing through the second AlGaN layer 33C and reaching the third GaN layer 33 A.

A method of manufacturing a light emitting element 2 according to the second embodiment shown in FIG. 4, same as or similar to the method of manufacturing a light emitting element 1 according to the first embodiment, includes forming each layer of the stack structure of the second light emitting element 2 above a substrate by, for example, MOCVD, and forming a first groove 901 and a second groove 902 in the stack structure formed above the substrate by, for example, RIE.

The same as or similar to the method of manufacturing a light emitting element 1 according to the first embodiment, a first layer 231 can be formed by lowering at least either the substrate heating temperature or the ammonia gas flow rate in the middle of forming the third nitride semiconductor layer 230, and a fourth layer 254 can be formed by lowering at least either the substrate heating temperature or ammonia gas flow rate in the middle of forming the fifth nitride semiconductor layer 250.

When forming a first groove 901 and a second groove 902 by RIE, deposits might adhere to the lateral surfaces defining the first groove 901 and the second groove 902. Such deposits can form a leakage current path between the electrodes 401 to 403 of different structures. The first layer 231 and the fourth layer 254 can reduce the leakage current flowing via the deposits.

### Variation

FIG. 14 shows a light emitting element 3 which is a variation of the first embodiment. The light emitting element 3 differs from the light emitting element 1 according to the first embodiment by including above the second light emitting part 102 a third light emitting part 103 which includes a sixth nitride semiconductor layer 60 containing a first conductivity type impurity, a seventh nitride semiconductor layer 70 containing a second conductivity type impurity, and a third active layer 63 positioned between the sixth nitride semiconductor layer 60 and the seventh nitride semiconductor layer 70. The light emitting element 3 further differs from the light emitting element 1 by having a fourth electrode 74 above the fourth connection face 60A of the sixth nitride semiconductor layer 60. The third active layer 63 is an emission layer that emits light and has, for example, an MQW structure. A fifth electrode 75 is formed above the fifth connection face 60B of the sixth nitride semiconductor layer 60, and the fifth electrode 75 functions as the cathode of the third light emitting part 103. A sixth electrode 76 is formed above the sixth connection face 70A of the seventh nitride semiconductor layer 70, and the sixth electrode 76 functions as the anode of the third light emitting part 103.

The sixth nitride semiconductor layer 60 includes a fourth layer 64, a fifth layer 65, and a sixth layer 66. The fourth layer 64 is positioned between the fifth layer 65 and the sixth layer 66. The fourth layer 64 contains an additive same as or similar to that contained in the first layer 31 of the first embodiment. The fourth layer 64 containing such an additive makes the resistivity of the fourth layer 64 higher than the resistivity of the fifth layer 65 and the resistivity of the sixth layer 66. This can reduce the leakage current flowing between the fifth electrode 75 and the fourth electrode 74. The additive concentration of the fourth layer 64 is higher than the additive concentration of the fifth layer 65 and the additive concentration of the sixth layer 66. The fourth layer 64 preferably contains C as the additive. The C concentration of the fourth layer 64 may be in a similar range to the C concentration range of the first layer 31.

The fourth layer 64 is smaller than the fifth layer 65 and the sixth layer 66 in thickness. The thickness of the fourth layer 64 may be in the same as or similar range to the thickness range of the first layer 31. The thickness of the fifth layer 65 may be in the same as or similar range to the thickness range of the second layer 32. The thickness of the sixth layer 66 may be in the same as or similar range to the thickness range of the third layer 33. The thickness of the sixth layer 66 may be larger than the thickness of the fifth layer 65.

The concentration of the first conductivity type impurity contained in the fourth layer 64 may be in the same as or similar range to that of the first conductivity type impurity contained in the first layer 31. The concentration of the first conductivity type impurity contained in the fifth layer 65 may be in the same as or similar range to that of the first conductivity type impurity contained in the second layer 32. The concentration of the first conductivity type impurity contained in the sixth layer 66 may be in the same as or similar range to that of the first conductivity type impurity contained in the third layer 33.

The fifth layer 65 is positioned between the fourth nitride semiconductor layer 40 of the second light emitting part 102 and the fourth layer 64. The sixth layer 66 is positioned between the fourth layer 64 and the third active layer 63.

In the light emitting element 3 according to the variation, the first active layer 61 of the first light emitting part 101 emits light having a first wavelength of which a peak wavelength is in a range of 440 nm to 470 nm. The second active layer 62 of the second light emitting part 102 emits light having a second wavelength of which a peak wavelength is in a range of 570 nm to 590 nm. The third active layer 63 of the third light emitting part 103 emits light having a third wavelength of which a peak wavelength is in a range of 590 nm to 770 nm. The first wavelength, the second wavelength, and the third wavelength are different from one another. The light emitting element 3 with the leakage current reduced between the light emitting parts by the first layer 31 and the fourth layer 64 allows the light emitting parts to emit light individually. The light emitting element 3 can produce light of a predetermined color by allowing the light emitting parts to emit light individually, or two or more light emitting parts to emit light simultaneously. The light emitting element 3 may output white light by allowing the first light emitting part 101, the second light emitting part 102, and the third light emitting part 103 to emit light simultaneously.

Similar to the first embodiment, the fifth layer 65 may include a GaN layer, an AlGaN layer, and a GaN layer successively from the fourth nitride semiconductor layer 40 side. The sixth layer 66 may include, successively from the fourth layer 64 side, a GaN layer, an AlGaN layer, and a GaN layer.

The light emitting element 3 may further include an eighth nitride semiconductor layer 80 positioned between the fourth nitride semiconductor layer 40 and the fifth layer 65. The eighth nitride semiconductor layer 80 contains a first conductivity type impurity, and forms an interface with the fourth nitride semiconductor layer 40 (pn junction). The concentration of the first conductivity type impurity contained in the eighth nitride semiconductor layer 80 is in the same as or similar range to the range of concentration of the first conductivity type impurity contained in the fifth nitride semiconductor layer 50. This can narrow the width of the depletion layer formed by the pn junction between the fourth nitride semiconductor layer 40 and the eighth nitride semiconductor layer 80, thereby facilitating the tunneling of electrons present in the valence band of the fourth nitride semiconductor layer 40 to the fifth layer 65.

### Electric Current Density Behavior Relative to Voltage

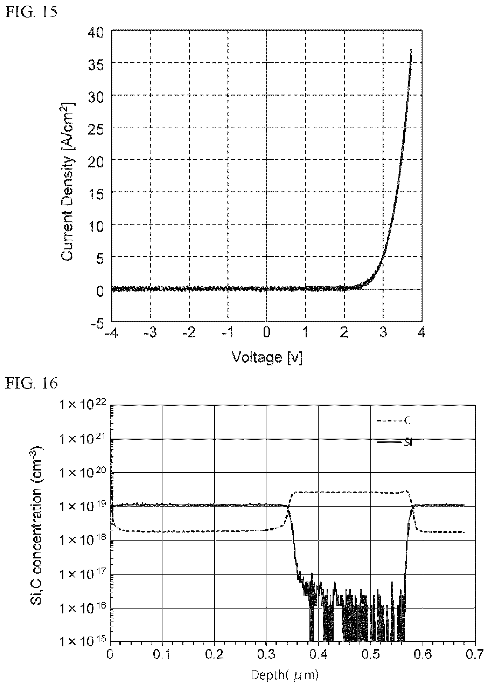

In this example, a light emitting element 1 shown in FIG. 1 was produced by MOCVD, and the emission of the second light emitting part 102 was checked. The percentage of In in the second active layer 62 was adjusted such that the second light emitting part 102 emits light having a second wavelength in a range of 570 nm to 590 nm. In this example, the third electrode 73 and the fourth electrode 74 were a common electrode. FIG. 15 is a graph showing the behavior of the current density relative to the voltage in the second light emitting part 102 of the light emitting element 1. From the graph, the light emitting element was found to have achieved good properties. In other words, it was found that the electrical conduction between the second electrode 72 and the fourth electrode 73 was good, and the leakage current between the second electrode 72 and the third electrode 73 was reduced.

### SIMS Analysis

In order to investigate the behavior of the C concentration, SIMS analyses were conducted on a sample of a wafer having the layering structure shown in FIG. 9. In the middle of forming the third nitride semiconductor layer 30 by MOCVD, the first layer 31 was formed by lowering the heating temperature of the substrate 100 and the ammonia gas flow rate. In other words, the second layer 32 and the first layer 31 were successively formed. The heating temperature of the substrate 100 during the formation of the first layer 31 was lowered only by 170°C as compared to the temperature used when forming the second layer 32. The ammonia gas flow rate was reduced to 5% of the ammonia gas flow rate used during the formation of the second layer 32. Subsequent to forming the first layer 31 to a predetermined thickness, the third layer 33 was formed by restoring the heating temperature of the substrate 100 and the ammonia gas flow rate to the initial settings. The introduction of the Si source gas was suspended at the time the formation of the first layer 31 began. As for the introduction of the Si source gas, the flow rate was also restored to the initial setting at the time the formation of the third layer 33 began.

FIG. 16 is a graph showing the ¹²C and ²⁸Si concentrations estimated from the SIMS analyses. The horizontal axis represents the depths, and the vertical axis represents the ¹²C and ²⁸Si concentrations, hereinafter simply referred to as the C concentration and Si concentration. In FIG. 16, the broken line shows the C concentrations, and the solid line shows the Si concentrations. The depths were obtained by converting the depths of sputtering marks measured by using a profilometer. The semiconductor layers analyzed had, successively from the surface side, the third layer 33, the first layer 31, and the second layer 32. For obtaining estimations from the SIMS analyses, primary ions (Cs⁺) were bombarded on the sample. The primary ion bombardment was conducted under two acceleration voltage conditions of 2 keV and 15 keV. FIG. 16 shows the results of the concentration conversions using the behavior of Si and C secondary iron intensities when the acceleration voltage was 15 keV. For the concentration conversions, a GaN layer with known Si concentrations and a C ion implanted into GaN layer were used as reference samples. With respect to C, however, the results obtained by converting the concentrations estimated under the 15 keV acceleration voltage condition into the concentrations estimated under the 2 keV acceleration voltage condition were used.

The results shown in FIG. 16 confirmed that the C concentration increased steeply at the same time the Si concentration declined steeply. Accordingly, it was found that a SIMS analysis makes it possible to differentiate the first layer 31, the second layer 32, and the third layer 33.

It was found from the SIMS results that, with respect to C concentrations, the C concentration of the first layer 31 was higher than the C concentration of the second layer 32 and the C concentration of the third layer 33 at the least. The C concentration of the first layer 31 was estimated to be 2.64 × 10¹⁹/cm⁻³. The C concentrations of the second layer 32 and the third layer 33 were estimated to be about 2.18 × 10¹⁸/cm⁻³. However, the second layer 32 and the third layer 33 having relatively low C concentrations are affected by ambient C, and this raises uncertainty with respect to the absolute concentration values. When measured at a 15 keV acceleration voltage, it was impossible to do a quantitative analysis of the C concentration of the second layer 32 which was affected by the first layer 31 which had a higher C concentration. However, because the intensities of the secondary ions of C of the second layer 32 and the third layer 33 were about the same when measured at a 2 keV acceleration voltage, the C concentrations were assumed to be about the same.

The Si concentrations estimated were 1.14 × 10¹⁹/cm⁻³ for the third layer 33, lower than 1.00x 10¹⁷/cm⁻³ for the first layer 31, and 1.11 × 10¹⁹/cm⁻³ for the second layer 32. The Si concentration of the first layer 31 was background or less.

The embodiments of the present disclosure can include the light emitting elements, light emitting devices, and the methods of manufacturing a light emitting element described below.

In the forgoing description, certain embodiments of the present invention have been described with reference to specific examples. The present invention is not limited to those specific examples. All forms implementable by a person skilled in the art by suitably making design changes based on any of the embodiments of the present invention described above also fall within the scope of the present invention so long as they encompass the subject matter of the present invention. Furthermore, various modifications and alterations within the spirit of the present invention that could have been made by a person skilled in the art also fall within the scope of the present invention.

The embodiments of the present invention can include following a light emitting diode, a light emitting device, and a method of the light emitting element.
1. A light emitting element comprising:
   a first light emitting part comprising:
      a first nitride semiconductor layer,
      a second nitride semiconductor layer, and
      a first active layer positioned between the first nitride semiconductor layer and the second nitride semiconductor layer, wherein:
         the first nitride semiconductor layer and the second nitride semiconductor layer contain impurities, and a conductivity type of the impurity of the second nitride semiconductor layer differs from a conductivity type of the impurity of the first nitride semiconductor layer;
   a second light emitting part positioned above the second nitride semiconductor layer, the second light emitting part comprising:
      a third nitride semiconductor layer,
      a fourth nitride semiconductor layer, and
      a second active layer positioned between the third nitride semiconductor layer and the fourth nitride semiconductor layer, wherein:
         the third nitride semiconductor layer comprises:
         a first layer that contains at least one selected from the group consisting of Be, Mg, Ca, Fe, Zn, and C,
         a second layer positioned between the second nitride semiconductor layer and the first layer, and
         a third layer positioned between the first layer and the second active layer, wherein:
      the second layer, the third layer, and the fourth nitride semiconductor layer contain impurities, and a conductivity type of the impurity of the fourth nitride semiconductor layer differs from a conductivity type of the impurity of the second layer and the third layer;
   a first electrode connected to the first nitride semiconductor layer;
   a second electrode connected to the third layer;
   a third electrode connected to the second layer; and
   a fourth electrode connected to the fourth nitride semiconductor layer.
2. The light emitting element according to clause 1, wherein:
   a thickness of the third layer is larger than a thickness of the second layer.
3. The light emitting element according to clauses 1 or 2, wherein:
   the second layer comprises a first GaN layer, a second GaN layer, and a first AlGaN layer;
   the second GaN layer is positioned closer to the first layer than the first GaN layer is;
   the first AlGaN layer is positioned between the first GaN layer and the second GaN layer; and
   the third electrode is connected to the first GaN layer or the first AlGaN layer.
4. The light emitting element according to any one of clauses 1 to 3, wherein:
   the third layer comprises a third GaN layer, a fourth GaN layer, and a second AlGaN layer;
   the fourth GaN layer is positioned farther away from the first layer than the third GaN layer is;
   the second AlGaN layer is positioned between the third GaN layer and the fourth GaN layer; and
   the second electrode is connected to the third GaN layer or the second AlGaN layer.
5. The light emitting element according to any one of clauses 1 to 4, wherein the thickness of the third layer is 0.5 to 1.2 times a thickness of the first nitride semiconductor layer.
6. The light emitting element according to any one of clauses 1 to 5, wherein:
   a peak wavelength of light from the first active layer is a first wavelength; and
   a peak wavelength of light from the second active layer is a second wavelength that differs from the first wavelength.
7. The light emitting element according to clause 6, wherein:
   the first wavelength is in a range of 440 nm to 470 nm; and
   the second wavelength is in a range of 570 nm to 590 nm.
8. The light emitting element according to any one of clauses 1 to 7, further comprising:
   a fifth nitride semiconductor layer containing an impurity of the conductivity type same as the conductivity type of the impurity contained in the first nitride semiconductor layer, positioned between the second nitride semiconductor layer and the second layer, and forming an interface with the second nitride semiconductor layer; wherein:
   a maximum value of a concentration of the impurity contained in the fifth nitride semiconductor layer is higher than a maximum value of a concentration of the impurity contained in the first nitride semiconductor layer and a maximum value of a concentration of the impurity contained in the third nitride semiconductor layer.
9. The light emitting element according to any one of clauses 1 to 8, wherein:
   the first layer contains C; and
   a C concentration of the first layer is higher than a C concentration of the second layer and a C concentration of the third layer.
10. The light emitting element according to clause 9, wherein a C concentration of the first layer is in a range of 1 × 1018/cm-3 to 1 × 1021/cm-3.
11. A light emitting element comprising:
   a first structure comprising:
      a first stack part, which is a first light emitting part and comprises:
         a first nitride semiconductor layer,
         a second nitride semiconductor layer,
         a first active layer positioned between the first nitride semiconductor layer and the second nitride semiconductor layer, wherein:
            the first nitride semiconductor layer and the second nitride semiconductor layer contain impurities, and a conductivity type of the impurity of the second nitride semiconductor layer differs from a conductivity type of the impurity of the first nitride semiconductor layer;
         a third nitride semiconductor layer containing an impurity of the conductivity type same as the conductivity type of the impurity contained in the first nitride semiconductor layer, and disposed above the second nitride semiconductor layer,
      a first electrode connected to the first nitride semiconductor layer, and
      a second electrode connected to the third nitride semiconductor layer;
   a second structure comprising:
      a second stack part, which is a second light emitting part and comprises:
         another first stack part,
         a fourth nitride semiconductor layer containing an impurity of the conductivity type same as the conductivity type of the impurity contained in the second nitride semiconductor layer,
         a second active layer positioned between the third nitride semiconductor layer and the fourth nitride semiconductor layer, and
         a fifth nitride semiconductor layer containing an impurity of the conductivity type same as the conductivity type of the impurity contained in the first nitride semiconductor layer, and disposed above the fourth nitride semiconductor layer,
      a third electrode connected to the third nitride semiconductor layer, and
      a fourth electrode connected to the fifth nitride semiconductor layer;
   a third structure comprising:
      a third stack part, which is a third light emitting part and comprises:
         another first stack part,
         another second stack part,
         a sixth nitride semiconductor layer containing an impurity of the conductivity type same as the conductivity type of the impurity contained in the second nitride semiconductor layer, and
         a third active layer positioned between the fifth nitride semiconductor layer and the sixth nitride semiconductor layer,
      a fifth electrode connected to the fifth nitride semiconductor layer, and
      a sixth electrode connected to the sixth nitride semiconductor layer;
   the third nitride semiconductor layer of the second structure comprises:
      a first layer that contains at least one selected from the group consisting of Be, Mg, Ca, Fe, Zn, and C,
      a second layer positioned between the second nitride semiconductor layer and the first layer, and
      a third layer positioned between the first layer and the second active layer, wherein:
         a thickness of the third layer is larger than a thickness of the second layer; the fifth nitride semiconductor layer of the third structure comprises:
         a fourth layer that contains at least one selected from the group consisting of Be, Mg, Ca, Fe, Zn, and C,
         a fifth layer positioned between the fourth nitride semiconductor layer and the fourth layer, and
         a sixth layer positioned between the fourth layer and the third active layer, wherein:
         a thickness of the sixth layer is larger than a thickness of the fifth layer.
12. The light emitting element according to clause 10, wherein:
   the third layer comprises a first GaN layer, a second GaN layer, and a first AlGaN layer;
   the second GaN layer is positioned farther away from the first layer than the first GaN layer is;
   the first AlGaN layer is positioned between the first GaN layer and the second GaN layer; and
   the third electrode is connected to the first GaN layer or the first AlGaN layer.
13. The light emitting element according to any one of clauses 10 to 12, wherein:
   the sixth layer comprises a third GaN layer, a fourth GaN layer, and a second AlGaN layer;
   the fourth GaN layer is positioned farther away from the fourth layer than the third GaN layer is;
   the second AlGaN layer is positioned between the third GaN layer and the fourth GaN layer; and
   the fifth electrode is connected to the third GaN layer or the second AlGaN layer.
14. A light emitting device comprising:
   one or more light emitting elements according to any one of clauses 1 to 13; and
   a wiring substrate above which the one or more light emitting elements are disposed, the wiring substrate comprising a first wiring part configured to supply an electric current between the third electrode and the first electrode, and a second wiring part configured to supply an electric current between the fourth electrode and the second electrode; wherein:
      the light emitting device does not comprise a wavelength conversion member containing a phosphor.
15. A light emitting device comprising:
   one or more light emitting elements according to any one of clauses 1 to 13; and
   a wiring substrate above which the one or more light emitting elements are disposed, the wiring substrate comprising a first wiring part configured to supply an electric current between the third electrode and the first electrode, and a second wiring part configured to supply an electric current between the fourth electrode and the second electrode; wherein:
      a peak wavelength of light from the first active layer is a first wavelength, and
      a peak wavelength of light from the second active layer is a second wavelength that differs from the first wavelength,
      the light emitting device emits visible light by combining light from the first active layer and light from the second active layer.
16. A method of a light emitting element comprising:
   providing a first light emitting part in which a first nitride semiconductor layer containing a first conductivity type impurity, a first active layer, and a second nitride semiconductor layer containing a second conductivity type impurity are successively stacked above a substrate,
   forming a third nitride semiconductor layer above the second nitride semiconductor layer by heating the substrate and introducing ammonia gas into the process chamber,
   providing a second light emitting part in which a second active layer and a fourth nitride semiconductor layer containing a second conductivity type impurity are successively stacked above the third nitride semiconductor layer,
   exposing the third nitride semiconductor layer and the first nitride semiconductor layer by partially etching off the second light emitting part and the first light emitting part, wherein:
      in the forming of the third nitride semiconductor layer, at least either a heating temperature of the substrate or a flow rate of the ammonia gas is lowered.
17. The method of the light emitting element according to clause 16 comprising:
   forming a fifth nitride semiconductor layer above the second nitride semiconductor layer such that a concentration of the first conductivity type impurity contained in the fifth nitride semiconductor layer is higher than a concentration of the first conductivity type impurity contained in the first nitride semiconductor layer and a concentration of the first conductivity type impurity contained in the third nitride semiconductor layer, wherein
   the third nitride semiconductor layer is formed above the fifth nitride semiconductor layer.
18. The method of the light emitting element according to clauses 16 or 17 comprising:
   in the forming of the third nitride semiconductor layer, forming a first GaN layer and a second GaN layer, and
   forming a first AlGaN layer to be positioned in the intermediate portion of the first GaN layer and the second GaN layer before lowering at least either the heating temperature of the substrate or the ammonia gas flow rate.
19. The method of the light emitting element according to any one of clauses 16 to 18 comprising:
   in the forming of the third nitride semiconductor layer, forming a third GaN layer and a fourth GaN layer, and
   forming a second AlGaN layer to be positioned in the intermediate portion of the third GaN layer and the fourth GaN layer after lowering at least either the heating temperature of the substrate or the ammonia gas flow rate.

## Claims

1. A light emitting element comprising:
a first light emitting part comprising:
a first nitride semiconductor layer,
a second nitride semiconductor layer, and
a first active layer positioned between the first nitride semiconductor layer and the second nitride semiconductor layer, wherein:
the first nitride semiconductor layer and the second nitride semiconductor layer contain impurities, and a conductivity type of the impurity of the second nitride semiconductor layer differs from a conductivity type of the impurity of the first nitride semiconductor layer;
a second light emitting part positioned above the second nitride semiconductor layer, the second light emitting part comprising:
a third nitride semiconductor layer,
a fourth nitride semiconductor layer, and
a second active layer positioned between the third nitride semiconductor layer and the fourth nitride semiconductor layer, wherein:
the third nitride semiconductor layer comprises:
a first layer that contains at least one selected from the group consisting of Be, Mg, Ca, Fe, Zn, and C,
a second layer positioned between the second nitride semiconductor layer and the first layer, and
a third layer positioned between the first layer and the second active layer, wherein:
the second layer, the third layer, and the fourth nitride semiconductor layer contain impurities, and a conductivity type of the impurity of the fourth nitride semiconductor layer differs from a conductivity type of the impurity of the second layer and the third layer;
a first electrode connected to the first nitride semiconductor layer;
a second electrode connected to the third layer;
a third electrode connected to the second layer; and
a fourth electrode connected to the fourth nitride semiconductor layer.

2. The light emitting element according to claim 1, wherein:
a thickness of the third layer is larger than a thickness of the second layer.

3. The light emitting element according to claims 1 or 2, wherein:
the second layer comprises a first GaN layer, a second GaN layer, and a first AlGaN layer;
the second GaN layer is positioned closer to the first layer than the first GaN layer is;
the first AlGaN layer is positioned between the first GaN layer and the second GaN layer; and
the third electrode is connected to the first GaN layer or the first AlGaN layer.

4. The light emitting element according to any one of claims 1 to 3, wherein:
the third layer comprises a third GaN layer, a fourth GaN layer, and a second AlGaN layer;
the fourth GaN layer is positioned farther away from the first layer than the third GaN layer is;
the second AlGaN layer is positioned between the third GaN layer and the fourth GaN layer; and
the second electrode is connected to the third GaN layer or the second AlGaN layer.

5. The light emitting element according to any one of claims 1 to 4, wherein the thickness of the third layer is 0.5 to 1.2 times a thickness of the first nitride semiconductor layer.

6. The light emitting element according to any one of claims 1 to 5, wherein:
a peak wavelength of light from the first active layer is a first wavelength; and
a peak wavelength of light from the second active layer is a second wavelength that differs from the first wavelength.

7. The light emitting element according to claim 6, wherein:
the first wavelength is in a range of 440 nm to 470 nm; and
the second wavelength is in a range of 570 nm to 590 nm.

8. The light emitting element according to any one of claims 1 to 7, further comprising:
a fifth nitride semiconductor layer containing an impurity of the conductivity type same as the conductivity type of the impurity contained in the first nitride semiconductor layer, positioned between the second nitride semiconductor layer and the second layer, and forming an interface with the second nitride semiconductor layer; wherein:
a maximum value of a concentration of the impurity contained in the fifth nitride semiconductor layer is higher than a maximum value of a concentration of the impurity contained in the first nitride semiconductor layer and a maximum value of a concentration of the impurity contained in the third nitride semiconductor layer.

9. The light emitting element according to any one of claims 1 to 8, wherein:
the first layer contains C; and
a C concentration of the first layer is higher than a C concentration of the second layer and a C concentration of the third layer.

10. The light emitting element according to claim 9, wherein a C concentration of the first layer is in a range of 1 × 10¹⁸/cm⁻³ to 1 × 10²¹/cm⁻³.

11. A light emitting device comprising:
one or more light emitting elements according to any one of claims 1 to 12; and
a wiring substrate above which the one or more light emitting elements are disposed, the wiring substrate comprising a first wiring part configured to supply an electric current between the third electrode and the first electrode, and a second wiring part configured to supply an electric current between the fourth electrode and the second electrode; wherein:
the light emitting device does not comprise a wavelength conversion member containing a phosphor.

12. A light emitting device comprising:
one or more light emitting elements according to any one of claims 1 to 12; and
a wiring substrate above which the one or more light emitting elements are disposed, the wiring substrate comprising a first wiring part configured to supply an electric current between the third electrode and the first electrode, and a second wiring part configured to supply an electric current between the fourth electrode and the second electrode; wherein:
a peak wavelength of light from the first active layer is a first wavelength, and
a peak wavelength of light from the second active layer is a second wavelength that differs from the first wavelength,
the light emitting device emits visible light by combining light from the first active layer and light from the second active layer.

13. A method of a light emitting element comprising:
providing a first light emitting part in which a first nitride semiconductor layer containing a first conductivity type impurity, a first active layer, and a second nitride semiconductor layer containing a second conductivity type impurity are successively stacked above a substrate,
forming a third nitride semiconductor layer above the second nitride semiconductor layer by heating the substrate and introducing ammonia gas into the process chamber,
providing a second light emitting part in which a second active layer and a fourth nitride semiconductor layer containing a second conductivity type impurity are successively stacked above the third nitride semiconductor layer,
exposing the third nitride semiconductor layer and the first nitride semiconductor layer by partially etching off the second light emitting part and the first light emitting part, wherein:
in the forming of the third nitride semiconductor layer, at least either a heating temperature of the substrate or a flow rate of the ammonia gas is lowered.

14. The method of the light emitting element according to claim 13 comprising:
forming a fifth nitride semiconductor layer above the second nitride semiconductor layer such that a concentration of the first conductivity type impurity contained in the fifth nitride semiconductor layer is higher than a concentration of the first conductivity type impurity contained in the first nitride semiconductor layer and a concentration of the first conductivity type impurity contained in the third nitride semiconductor layer, wherein
the third nitride semiconductor layer is formed above the fifth nitride semiconductor layer.

15. The method of the light emitting element according to claims 13 or 14 comprising:
in the forming of the third nitride semiconductor layer, forming a first GaN layer and a second GaN layer, and
forming a first AlGaN layer to be positioned in the intermediate portion of the first GaN layer and the second GaN layer before lowering at least either the heating temperature of the substrate or the ammonia gas flow rate.

16. The method of the light emitting element according to any one of claims 13 to 15 comprising:
in the forming of the third nitride semiconductor layer, forming a third GaN layer and a fourth GaN layer, and
forming a second AlGaN layer to be positioned in the intermediate portion of the third GaN layer and the fourth GaN layer after lowering at least either the heating temperature of the substrate or the ammonia gas flow rate.
